# EUROPEAN PATENT APPLICATION

(11) **EP 4 832 684 A1**
(43) Date of publication of application: **28.10.2026**
(21) Application number: 26172763.0
(22) Date of filing: 31.08.2019
(51) Int. Cl.: H05K 7/20, G06F 1/20

(54) **HEAT DISSIPATION APPARATUS, DEVICE, RACK, AND SYSTEM**

(62) Document number(s) of the earlier application(s) in accordance with Art. 76 EPC: 19943205.5 / 3 968 745
(71) Applicant: HUAWEI TECHNOLOGIES CO., LTD., Shenzhen 518129 (CN)
(72) Inventor: GONG, Xinhu, Shenzhen, 518129 (CN); XIA, Gaoliang, Shenzhen, 518129 (CN)
(74) Representative: Isarpatent

(57) **Abstract**

This application provides a heat dissipation apparatus, a device, a rack, and a system. The heat dissipation apparatus mainly includes a heat-conducting plate, where a liquid channel is disposed on a first surface of the heat-conducting plate; a mounting base, where an accommodation cavity configured to accommodate a partial area that is in the heat-conducting plate and that includes a second surface is disposed on the mounting base, and the first surface and the second surface are disposed opposite to each other; and a pressing plate, configured to fasten the heat-conducting plate in the accommodation cavity, where the pressing plate is detachably and firmly connected to the mounting base, a sealing cavity is formed between the pressing plate and the first surface of the heat-conducting plate, the sealing cavity is configured to accommodate the liquid channel, and a liquid inlet connector and a liquid outlet connector that are connected to the liquid channel are disposed on the pressing plate. In the foregoing structure, the entire heat dissipation apparatus uses a modularized standard separated structure, and the pressing plate and the mounting base may be made into standard parts. When heat dissipation is performed on chips having different heat dissipation requirements, only a corresponding heat-conducting plate needs to be selected as required, and the mounting base and the pressing plate may still be used. This improves adaptability of the heat dissipation apparatus.

## Description

### TECHNICAL FIELD

This application relates to the field of heat dissipation technologies, and in particular, to a heat dissipation apparatus, a device, a rack, and a system.

### BACKGROUND

With rapid development of the information technology (internet technology, 1T) field, a computing speed of a chip in a device (for example, a server and a storage device) is increasingly fast. However, as a processing capability of the chip is improved, heat generated by the chip also increases. For a conventional device, heat is usually dissipated for the chip in a liquid cooling heat dissipation manner.

In the liquid cooling heat dissipation manner, a liquid cooling heat dissipation apparatus needs to be installed on the chip, and heat is dissipated from the chip by circulating liquid inside the heat dissipation apparatus. When the liquid heat dissipation apparatus is assembled, the liquid heat dissipation apparatus usually uses an integrated structure, and is fastened to the chip by using a floating screw. However, when the heat dissipation apparatus with the integrated structure is used to perform heat dissipation for chips with different specifications, the apparatus needs to be correspondingly adapted according to a specification of each chip. In addition, a component layout in a device in which the chip is located needs to be considered. Consequently, there are various specifications of the heat dissipation apparatus.

### SUMMARY

This application provides a heat dissipation apparatus, a device, a rack, and a system, to improve adaptability of the heat dissipation apparatus.

According to a first aspect, a heat dissipation apparatus is provided. The heat dissipation apparatus is configured to dissipate heat for a chip. The heat dissipation apparatus uses a separated structure, and mainly includes a heat-conducting plate, a mounting base, and a pressing plate. The mounting base, the heat-conducting plate, and the pressing plate are disposed in a sandwich laminated manner, and the heat-conducting plate is located between the mounting base and the pressing plate. The heat-conducting plate includes a first surface and a second surface that are disposed opposite to each other, the mounting base is configured to bear the heat-conducting plate, and an accommodation cavity configured to accommodate a partial area that is in the heat-conducting plate and that includes the second surface is disposed on the mounting base. The heat-conducting plate is used as a main structure of the heat dissipation apparatus, and a liquid channel is disposed on the first surface of the heat-conducting plate, and is configured for liquid flowing. The pressing plate is configured to fasten the heat-conducting plate into the accommodation cavity of the mounting base. The pressing plate is detachably connected to the mounting base, a sealing cavity is formed between the pressing plate and the first surface of the heat-conducting plate, and the sealing cavity is configured to accommodate the liquid channel. In addition, a liquid inlet connector and a liquid outlet connector that are connected to the liquid channel are disposed on the pressing plate. During use, the liquid inlet connector and outlet connector are separately connected to an external pipe. Liquid flows into the liquid channel through the liquid inlet connector to dissipate heat for the chip, and then flows out of the external pipe through the liquid outlet connector to form a circulation. In the foregoing structure, the entire heat dissipation apparatus uses a modularized standard separated structure, and the pressing plate and the mounting base may be made into standard parts. When heat dissipation is performed on chips having different heat dissipation requirements, only a corresponding heat-conducting plate needs to be selected as required, and the mounting base and the pressing plate may still be used. Compared with an integral liquid heat dissipation apparatus, the heat dissipation apparatus in the present invention eliminates the need to select different liquid heat dissipation apparatuses for different chips, enhances universality, and improves adaptability of the heat dissipation apparatus. In addition, a modularized standard is used to reduce production difficulty of the heat dissipation apparatus, and make a manufacturing process easier.

In a possible design, the heat-conducting plate includes a substrate configured to be clamped into the accommodation cavity, and a heat dissipation structure firmly disposed on the substrate, and the heat dissipation structure is the liquid channel. The substrate and an accommodating groove are relatively fastened through fitting between the substrate and the accommodating groove.

In another possible design, an accommodation groove that accommodates the heat dissipation structure is disposed on the pressing plate. The liquid channel is covered by the accommodation groove and the liquid channel is sealed.

In another possible design, the heat dissipation structure may be a pipe, a groove, or a capillary structure. In other words, different structures may be used to form the liquid channel.

In another possible design, the pressing plate is sealed with and connected to the substrate by using a sealing gasket. The sealing gasket is used to seal the pressing plate and the liquid channel.

In another possible design, a placement groove is disposed on the substrate, and the sealing gasket is disposed in the placement groove.

In another possible design, a first position-limiting protrusion is disposed in the accommodation cavity of the mounting base, and a second position-limiting protrusion clamped with the first position-limiting protrusion is disposed on the substrate. The pressing plate can tightly press the heat-conducting plate onto the mounting base through fitting between the first position-limiting protrusion and the second position-limiting protrusion. The mounting base uses a frame-shaped hollow structure, so that the heat-conducting plate can be directly connected to the chip by using a heat-conducting adhesive or another heat-conducting medium. This improves a heat transfer effect of the heat-conducting plate for the chip.

In another possible design, a third position-limiting protrusion is disposed on the substrate, and the third position-limiting protrusion abuts against a surface of the mounting base. The pressing plate can tightly press the heat-conducting plate onto the mounting base through fitting between the third position-limiting protrusion and the mounting base.

In another possible design, the heat dissipation apparatus further includes a pressing cover, where the pressing cover is detachably and firmly connected to the mounting base, and the pressing cover is pressed onto the heat-conducting plate.

In another possible design, stiffness of the pressing cover is greater than stiffness of the pressing plate. The liquid channel between the pressing plate and the heat-conducting plate may further be fastened by using the pressing cover, to prevent the liquid from flowing out of the heat dissipation apparatus. In addition, when the liquid in the liquid channel flows too fast, the pressing plate needs to bear relatively large acting force, which easily causes expansion of the pressing plate. A reinforcement structure of the pressing cover may also assist the pressing cover in bearing a part of the acting force, to avoid problems such as expansion of the pressing plate and liquid leakage.

In another possible design, at least one of the liquid inlet connector and the liquid outlet connector is rotationally connected to the pressing plate. When the liquid inlet connector or the liquid outlet connector is rotationally disposed, a connection direction of the liquid inlet connector or the liquid outlet connector may be adjusted, so that a position of the liquid inlet connector or the liquid outlet connector connected to the external pipe may be adjusted according to a specific implementation requirement. This reduces a space requirement of a heat sink and improves adaptability of the heat sink.

In another possible design, both the liquid inlet connector and the liquid outlet connector are firmly connected to the pressing plate.

In another possible design, both the liquid inlet connector and the liquid outlet connector each are an inverted L-shaped connector.

In another possible design, the liquid inlet connector and the liquid outlet connector are separately connected to the pressing plate by using a sealing ring, to ensure connection sealing.

In another possible design, the pressing cover tightly presses the liquid outlet connector and the liquid inlet connector onto the pressing plate. Positions of the liquid outlet connector and the liquid inlet connector are limited by using the pressing cover.

In another possible design, bosses that are in a one-to-one correspondence with the liquid inlet connector and the liquid outlet connector are disposed on the pressing plate, each boss has a mounting groove, the liquid inlet connector or the liquid outlet connector has a convex shoulder assembled in the mounting groove, and the pressing cover tightly presses the convex shoulder into the mounting groove.

In another possible design, when the pressing cover does not tightly press the convex shoulder into the mounting groove, the convex shoulder may rotate relative to the mounting groove.

In another possible design, a side wall of the mounting groove has a plurality of position-limiting protrusions, and the convex shoulder has a position-limiting groove fitting with each position-limiting protrusion; or a side wall of the mounting groove has a plurality of position-limiting grooves, and the convex shoulder has a position-limiting protrusion fitting with each position-limiting groove.

In another possible design, the pressing plate is a rectangle, and the liquid inlet connector and the liquid outlet connector are disposed in a diagonal manner. Certainly, the liquid inlet connector and the liquid outlet connector may alternatively be located on a same side of the pressing plate.

In another possible design, a floating screw configured to connect to the chip is disposed on the mounting base, to ensure sufficient pressure when the mounting base is connected to the chip.

In another possible design, the second surface of the heat-conducting plate is at least greater than or equal to a surface area of a to-be-heat-dissipated chip, and the second surface is a surface that is of the chip and that is used to connect to the heat-conducting plate in a heat-conducting manner.

In another possible design, the sealing cavity is filled with liquid, and the liquid flows in the liquid channel.

In another possible design, the heat dissipation apparatus is configured to connect to a cooling system, cold liquid in the cooling system enters the sealing cavity of the heat dissipation apparatus, heat generated by the chip is transferred to the liquid by using the heat-conducting plate, a temperature of the liquid increases after absorbing the heat, and the high-temperature liquid flows back to the cooling system for cooling.

According to a second aspect, a device is provided. The device includes a mainboard, a chip disposed on the mainboard, and the heat dissipation apparatus that is firmly connected to the mainboard and that is used to dissipate heat for the chip. In the foregoing structure, the entire heat dissipation apparatus uses a modularized standard separated structure, and the pressing plate and the mounting base may be made into standard parts. When heat dissipation is performed on chips having different heat dissipation requirements, only a corresponding heat-conducting plate needs to be selected as required, and the mounting base and the pressing plate may still be used. Compared with the prior art in which different liquid heat dissipation apparatuses need to be selected for different chips in an integral liquid heat dissipation apparatus, the present invention improves adaptability of the heat dissipation apparatus. In addition, a modularized standard is used to reduce production difficulty of the heat dissipation apparatus, and facilitates processing.

In a possible design, a cooling system is further included. The cooling system includes a liquid inlet pipe and a liquid outlet pipe. The liquid inlet pipe is sealed with and connected to a liquid inlet connector, and the liquid outlet pipe is sealed with and connected to a liquid outlet connector. A circulation loop is formed to dissipate heat for the chip through fitting between the cooling system and the heat dissipation apparatus.

According to a third aspect, a rack is provided. The rack includes the foregoing heat dissipation apparatus or the foregoing device.

According to a fourth aspect, a system is provided. The system includes the heat dissipation apparatus and the cooling system according to any one of the first aspect or the possible implementations of the first aspect. The cooling system includes a power apparatus configured to enable liquid to flow in a liquid channel in the heat dissipation apparatus and a cooling apparatus configured to cool liquid in the heat dissipation apparatus.

In this application, the implementations provided in the foregoing aspects may further be combined to provide more implementations.

### BRIEF DESCRIPTION OF DRAWINGS

FIG. 1 is a schematic structural diagram of a device according to this application;
FIG. 2 is a schematic structural diagram of a heat dissipation apparatus according to this application;
FIG. 3 is a schematic exploded diagram of a heat dissipation apparatus according to this application;
FIG. 4 is a schematic structural diagram of a first type of mounting base according to this application;
FIG. 5 is a schematic diagram of fitting between a first type of mounting base and a heat-conducting plate according to this application;
FIG. 6 is a schematic structural diagram of a second type of mounting base according to this application;
FIG. 7 is a schematic diagram of fitting between a second type of mounting base and a heat-conducting plate according to this application;
FIG. 8 is a schematic diagram of a third type of mounting base according to this application;
FIG. 9 is a sectional view of fitting between a third type of mounting base and a chip according to this application;
FIG. 10 is a schematic structural diagram of a first type of heat-conducting plate according to this application;
FIG. 11 is a schematic exploded diagram of a first type of heat-conducting plate according to this application;
FIG. 12 is a sectional view of a heat dissipation apparatus according to this application;
FIG. 13 is a schematic structural diagram of a second type of heat-conducting plate according to this application;
FIG. 14 is a schematic structural diagram of a third type of heat-conducting plate according to this application;
FIG. 15 is a schematic structural diagram of a pressing plate according to this application;
FIG. 16 is a sectional view of A-A in FIG. 15;
FIG. 17 is a schematic exploded diagram of a pressing plate according to this application;
FIG. 18 to FIG. 21 are schematic diagrams of rotation of a liquid outlet connector according to this application;
FIG. 22 is a schematic diagram of fitting between a pressing plate and a pressing cover according to this application;
FIG. 23 is a schematic application diagram of a heat dissipation apparatus according to this application;
FIG. 24 is a schematic diagram of a rack according to this application; and
FIG. 25 is a schematic diagram of connection between a heat dissipation apparatus and a cooling system according to this application.

### Reference signs:

10-heat dissipation apparatus 11-pressing plate 111-accommodation groove 112-liquid outlet connector
113-liquid inlet connector 1131-protrusion structure 1132-convex shoulder 1133-position-limiting groove
114-sealing ring 115-boss 1151-position-limiting protrusion 1152-mounting groove
12-mounting base 121-surface 122-accommodation cavity 123-position-limiting protrusion
124-assembly hole 125-mounting hole 126-surface 13-heat-conducting plate
131-position-limiting protrusion 132-position-limiting protrusion 133-substrate 1331-placement groove
134-sealing gasket 135-heat dissipation structure 1351-capillary structure 1352-metal sheet
1353-pipe 136-surface 137-surface 14-pressing cover
141-through hole 20-chip 30-mainboard 40-connecting piece
50-cooling apparatus 51-liquid inlet pipe 52-liquid outlet pipe 60-rack
61-liquid inlet pipe 62-liquid outlet pipe 70-power apparatus

### DESCRIPTION OF EMBODIMENTS

For ease of understanding, an application scenario of a heat dissipation apparatus provided in this application is first described.

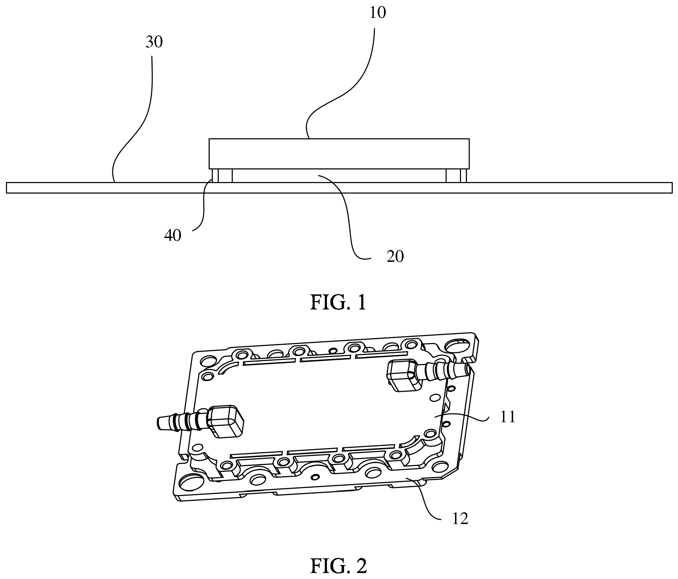

The heat dissipation apparatus provided in this application is configured to dissipate heat for a chip in a device. The device may be a server, a storage device, a router, a switch, or the like. The storage device includes a data storage device such as a storage array or a backup device. FIG. 1 is a schematic structural diagram of a device according to this application. As shown in the figure, the device includes a heat dissipation apparatus 10, a chip 20, a mainboard 30, and a connecting piece 40. In an assembly process of the device, the chip 20 is born by the mainboard 30 (which may also be referred to as a printed circuit board (print circuit board, PCB) of the device. The heat dissipation apparatus 10 is firmly connected to the mainboard 30 that bears the chip 20 by using the connecting piece 40, and the fastened connection is detachable.

It should be understood that the mainboard 30 bears the chip is merely an example, and the chip 20 may alternatively be born by another part of the device. This is not limited in this application.

The heat dissipation apparatus 10 may dissipate heat for the chip 20. An area of an effective heat dissipation surface of the heat dissipation apparatus may be greater than or equal to an area of a surface on which a to-be-heat-dissipated chip is in contact with the heat dissipation apparatus, to ensure effective heat dissipation for the to-be-heat-dissipated chip. The effective heat dissipation surface of the heat dissipation apparatus is an area of a surface that is in the heat dissipation apparatus and that is used to connect to the to-be-heat-dissipated chip. The part is used to conduct heat generated by the to-be-heat-dissipated chip to the heat dissipation apparatus 10, and then the heat dissipation apparatus 10 conducts the heat to the outside of the device, to implement a heat dissipation function for the chip. The heat dissipation apparatus 10 in FIG. 1 may dissipate heat for only one chip 20, or may dissipate heat for a plurality of chips 20 at the same time.

Optionally, when a same heat dissipation apparatus dissipates heat for a plurality of chips, to ensure effective heat dissipation for the plurality of chips, an area of an effective heat dissipation surface of the heat dissipation apparatus may be greater than or equal to an area of a surface on which all to-be-heat-dissipated chips are in contact with the heat dissipation apparatus. For ease of description, in the following embodiments of this application, an example in which a same heat dissipation apparatus in FIG. 1 dissipates heat for only one chip is used for description.

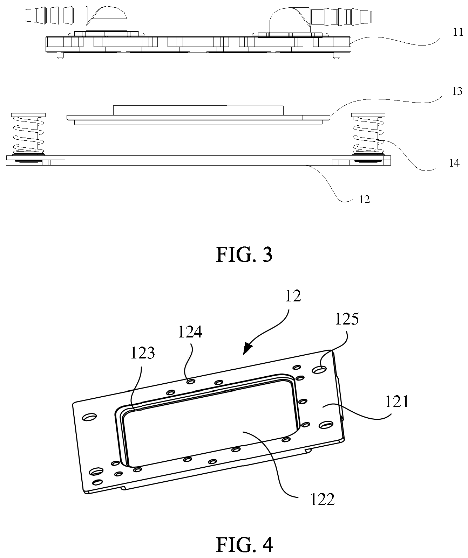

FIG. 2 is a schematic structural diagram of a heat dissipation apparatus according to this application. FIG. 3 is a schematic exploded diagram of a heat dissipation apparatus according to this application. As shown in FIG. 2 and FIG. 3, the heat dissipation apparatus mainly includes a mounting base 12, a heat-conducting plate 13, and a pressing plate 11. The mounting base 12 is configured to be fastened to the mainboard 30 by using the connecting piece 40 in FIG. 1, the heat-conducting plate 13 is configured to conduct heat for the chip 20, and the pressing plate 11 is configured to fasten the heat-conducting plate 13 onto the mounting base 12. During assembly, the mounting base 12, the heat-conducting plate 13, and the pressing plate 11 are disposed in a sandwich laminated manner, and the heat-conducting plate 13 is located between the mounting base 12 and the pressing plate 11. The pressing plate 11 is detachably connected to the mounting base 12. The pressing plate 11 and the mounting base 12 in FIG. 3 tightly press the heat-conducting plate 13 onto the mounting base 12 by using a threaded connecting piece 14 (for example, a bolt or a screw). The pressing plate 11 may be made of a metal material, for example, aluminum, iron, steel, or alloy, or may be made of plastic or a plastic material. A size of the pressing plate 11 adapts to the heat-conducting plate 13, and an area of the pressing plate 11 may be greater than or equal to an area of the heat-conducting plate 13, to ensure that the pressing plate 11 has a sufficient size to cover a surface of the heat-conducting plate 13.

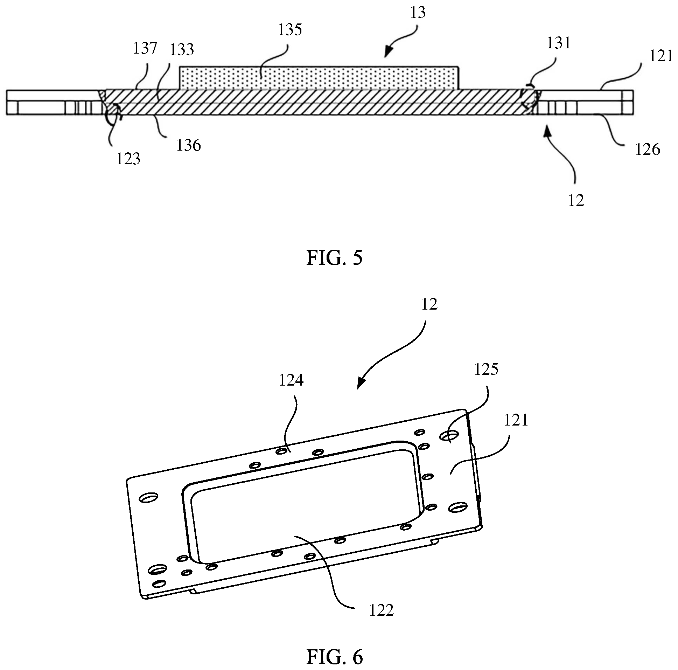

Referring to FIG. 4 and FIG. 5, FIG. 4 is a schematic structural diagram of a first type of mounting base according to this application, and FIG. 5 is a sectional view of a combination of a mounting base and a heat-conducting plate according to this application. FIG. 5 is a sectional view of the mounting base along a laminated direction of the pressing plate, the heat-conducting plate, and the mounting base in FIG. 2. The mounting base 12 uses a hollow frame-shaped structure, and the frame-shaped structure has two opposite surfaces: a surface 121 and a surface 126. The surface 121 is a surface used to attach to the heat-conducting plate, and the surface 126 is a surface used to connect to the chip. For ease of description, the surface 121 may also be referred to as a first surface, and the surface 126 may be referred to as a second surface. Referring to FIG. 4, the mounting base 12 is used as a connection structure of fitting between the heat dissipation apparatus and the chip. A plurality of mounting holes 125 are disposed on an edge of the mounting base 12. When the heat dissipation apparatus is fastened onto the chip, the heat dissipation apparatus is connected to the mainboard that bears the chip by using the threaded connecting piece (the bolt or the screw) through the mounting holes 125, and the connection structure is detachable. In the mounting base 12 in FIG. 4, there are four mounting holes 125, and the four mounting holes 125 are respectively located in frame-shaped corner areas. In addition, a plurality of assembly holes 124 are further disposed on the mounting base 12. The assembly holes 124 are configured to enable the threaded connecting piece (the bolt or the screw) to penetrate through the assembly holes, to fasten the pressing plate. The plurality of assembly holes 124 are disposed around a hollow part of the mounting base 12. FIG. 4 shows only an arrangement manner of the mounting holes 125 and the mounting holes 124. During specific implementation, a quantity of the mounting holes 125 and a quantity of the mounting holes 124 do not constitute a limitation on this application. Quantities and positions of the mounting holes 125 and the mounting holes 124 may be set on the mounting base 12 according to an actual mounting requirement.

Referring to FIG. 4, the hollow part of the mounting base 12 is an accommodation cavity 122 configured to place the heat-conducting plate, and the hollow part of the mounting base 12 refers to forming a hole in an area using a center point of the mounting base 12 as a basis. A cross section of the area may be a rectangle, a square, a circle, or another shape, and a specific shape matches a shape of a partial the heat-conducting plate that is placed in the accommodation cavity. The center point is a position of a center of the mounting base. For example, when the mounting base 12 uses a rectangular structure, the center point is an intersection point of diagonal lines. Referring to FIG. 5, when the heat-conducting plate 13 is assembled, a part of the heat-conducting plate 13 is inserted into the accommodation cavity 122 in FIG. 4. As shown in FIG. 5, a structure of the heat-conducting plate 13 is also described. The heat-conducting plate 13 includes a substrate 133 and a heat dissipation structure 135 disposed on the substrate, and the substrate 133 is inserted into the accommodation cavity. During specific fitting, as shown in FIG. 5, a position-limiting protrusion 123 is disposed in the accommodation cavity 122, the position-limiting protrusion 123 is disposed around an inner wall of the accommodation cavity 122 for one circle, and a disposing position of the position-limiting protrusion 123 is close to the surface 126 of the mounting base 12. The substrate 133 of the heat-conducting plate 13 has a position-limiting protrusion 131 clamped with the position-limiting protrusion 123. The position-limiting protrusion 123 of the mounting base 12 may also be referred to as a first position-limiting protrusion, and the position-limiting protrusion 126 of the heat-conducting plate 13 may also be referred to as a second position-limiting protrusion. A volume of the accommodation cavity 122 may be greater than or equal to a volume of an insertion part of the heat-conducting plate 13, to ensure that the base 12 and the heat-conducting plate 13 can be smoothly combined.

When the heat-conducting plate 13 is inserted into the accommodation cavity 122, the position-limiting protrusion 131 is in contact with the position-limiting protrusion 123, and limits an insertion depth of the heat-conducting plate 13, so that a surface 136 that is of the heat-conducting plate 13 and that is connected to the to-be-heat-dissipated chip is exposed to the surface 121 of the mounting base 12. The surface 136 of the heat-conducting plate 13 is an effective heat dissipation area of the heat dissipation apparatus described in the foregoing content. For ease of description, the surface 136 may be referred to as a second surface, and an area of the second surface is at least greater than or equal to a surface area of the to-be-heat-dissipated chip. After the heat-conducting plate and the mounting base are assembled, the surface 136 of the heat-conducting plate 13 and the surface 126 of the mounting base 12 may be located on a same horizontal plane, so that the heat-conducting plate 13 may be directly connected to the chip by using a heat-conducting adhesive or another heat-conducting medium.

Optionally, the position-limiting protrusion 123 in FIG. 5 is merely an example. Alternatively, a structure in which a plurality of position-limiting protrusions 123 are disposed may be used, and the plurality of position-limiting protrusions 123 are spaced around a side wall of an accommodating groove, or another position-limiting structure may be used to limit an insertion depth of the heat-conducting plate.

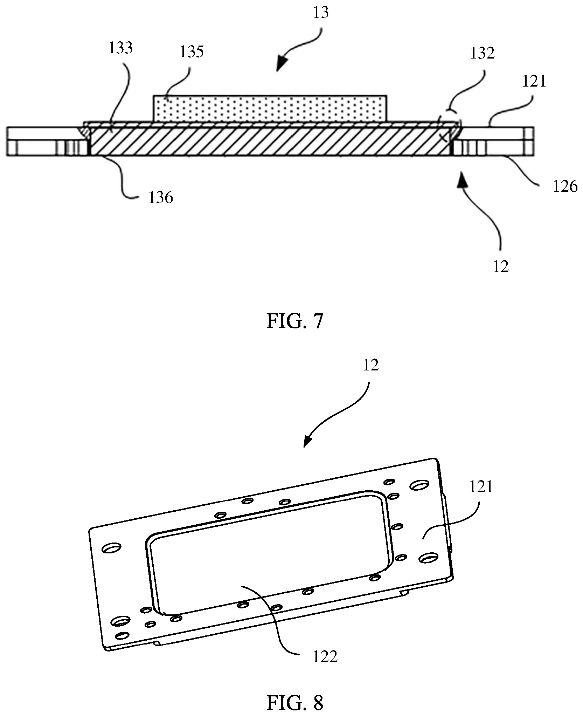

In a possible embodiment, FIG. 6 shows a structure of a second type of mounting base according to this application. For a part of the mounting base in FIG. 6 that has a same reference sign as that in FIG. 4 or FIG. 5, refer to FIG. 4 or FIG. 5. As shown in FIG. 6, the mounting base 12 uses a frame structure. A difference between the mounting base 12 in FIG. 6 and the mounting base 12 in FIG. 4 lies in that the accommodation cavity 122 of the frame structure in FIG. 6 does not have the position-limiting protrusion, but a position-limiting structure is disposed on the heat-conducting plate 13. As shown in FIG. 7, FIG. 7 is a sectional view of fitting between the mounting base 12 and the heat-conducting plate 13. FIG. 7 is a sectional view of the mounting base along a laminated direction of the pressing plate, the heat-conducting plate, and the mounting base in FIG. 2. For a part that has a same reference sign as that in FIG. 5, refer to the description in FIG. 5. A position-limiting protrusion 132 is disposed on the heat-conducting plate 12, and the position-limiting protrusion 132 abuts against the surface 121 of the mounting base to limit an insertion depth of the heat-conducting plate. For ease of description, and distinguishing between the position-limiting protrusion 132 in FIG. 7 and the first position-limiting protrusion and the second position-limiting protrusion in FIG. 4 and FIG. 5, the position-limiting protrusion 132 may also be referred to as a third position-limiting protrusion. During assembly, the substrate 133 of the heat-conducting plate 13 is inserted into the accommodation cavity 122, and the heat-conducting plate 13 limits, by using the position-limiting protrusion 132, a depth at which the heat-conducting plate 13 is inserted into the mounting base 12. After the assembly is completed, the surface 136 connected to the to-be-heat-dissipated chip in the heat-conducting plate 13 and the surface 126 of the mounting base 12 may be located on a same horizontal plane or close to a same horizontal plane, and the heat-conducting plate 13 may be directly connected to the chip in a heat-conducting manner.

Optionally, a sealing gasket may further be disposed at an edge of the accommodation cavity 122, to further seal and fasten the position-limiting protrusion 132 of the heat-conducting plate 13.

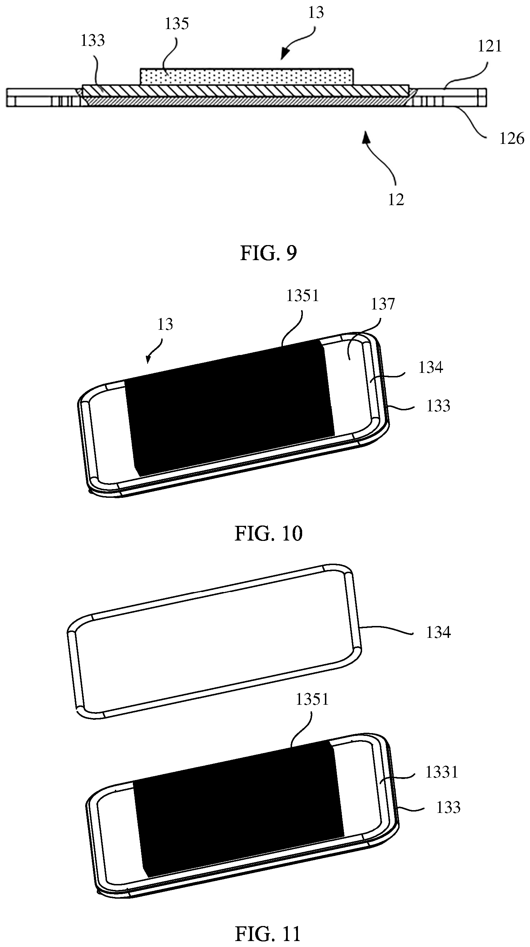

In another possible embodiment, FIG. 8 is a schematic structural diagram of a third type of mounting base according to this application, and FIG. 9 is a sectional view of fitting between a third type of mounting base and a chip according to this application. FIG. 9 is a sectional view of the mounting base along a laminated direction of the pressing plate, the heat-conducting plate, and the mounting base in FIG. 2. For a part that has a same reference sign as that in FIG. 5, refer to the description in FIG. 5. A difference between the third type of mounting base and the first type and the second type of mounting base lies in that, the accommodation cavity of the first type and the second type of mounting base uses the hollow frame-shaped structure, and the third type of mounting base uses a groove structure. To be specific, a thickness of a groove bottom of the third type of mounting base is a first value, and the first value may be set according to a specific requirement, to ensure that the heat-conducting plate can conduct heat of the chip by using the groove bottom. This can effectively dissipate heat for the chip. Specifically, the mounting base 12 uses a plate structure, and the mounting base 12 has a surface 121 and a surface 126 that are opposite to each other. The surface 121 is a surface used to attach to the heat-conducting plate 13, and the surface 126 is a surface connected to the chip 20. A groove is disposed on the surface 121, and a hollow part of the groove forms an accommodation cavity 122 that accommodates the heat-conducting plate 13. During assembly, the heat-conducting plate 13 is fastened in the groove, and when the heat-conducting plate 13 is inserted into the groove, the heat-conducting plate 13 is connected to a bottom wall of the groove. When the heat dissipation apparatus is combined with the chip, heat generated by the chip is transferred to the bottom wall of the mounting base 12, and then is conducted to the heat-conducting plate 13 by using the bottom wall of the mounting base 12.

It can be learned from FIG. 4, FIG. 6, and FIG. 8 that the mounting base provided in this application may be implemented in different structural forms provided that the mounting base has the accommodation cavity that accommodates the heat-conducting plate. A specific structure of the accommodation cavity on the mounting base and the fitting relationship between the mounting base and the heat-conducting plate may be set according to a service requirement.

The foregoing describes the structure of the mounting base provided in this application with reference to FIG. 2 to FIG. 9. The following further describes a structure of a heat-conducting plate provided in the embodiments of this application with reference to FIG. 10 to FIG. 21.

The heat-conducting plate provided in this application is used as a main component of a heat dissipation apparatus, and has a first surface and a second surface that are opposite to each other. A liquid channel is disposed on the first surface of the heat-conducting plate, and the second surface of the heat-conducting plate is configured to connect to a chip. During specific implementation, as shown in FIG. 5, the heat-conducting plate 13 includes the substrate 133 and the heat dissipation structure 135 firmly disposed on the substrate. The heat dissipation structure 135 may be different structures such as a liquid channel, a capillary structure, or a pipe. The first surface and the second surface are two opposite surfaces 136 and 137 of the substrate 13. A thickness of the substrate 133 may be set according to a specific implementation requirement. This is not limited in this application. To improve a heat-conducting effect, the substrate may be thinned as much as possible.

As shown in FIG. 10, FIG. 10 is a schematic structural diagram of a heat-conducting plate according to this application. As shown in the figure, the substrate 133 of the heat-conducting plate 13 may be completely or partially clamped in the accommodation cavity 122 of the mounting base 12. In addition, a shape and a structure of the partial heat-conducting plate 13 clamped in the accommodation cavity 122 match a shape and a structure of the accommodation cavity of the mounting base 12. When the mounting base 12 is the mounting base 12 of different structural forms in FIG. 4, FIG. 6, or FIG. 8, the substrate 133 may adapt to the mounting base 12 by using a corresponding structure. For ease of description, that the mounting base 12 uses the structure in FIG. 4 is used as an example. Referring to FIG. 5 and FIG. 10, FIG. 10 is a schematic structural diagram of a first type of heat-conducting plate according to this application. FIG. 5 is a sectional view of the first type of heat-conducting plate along a laminated direction of the pressing plate, the heat-conducting plate, and the mounting base in FIG. 2. First, referring to FIG. 10, the substrate 133 on the heat-conducting plate 13 uses a rectangular plate structure. Referring to FIG. 5, the substrate 133 has the surface 136 and the surface 137 that are opposite to each other. For ease of description, the surface 136 may also be referred to as a second surface of the heat-conducting plate 13, and the surface 137 is a first surface of the heat-conducting plate 13. Still referring to FIG. 5, the position-limiting protrusion 131 is correspondingly disposed on a side wall of the substrate 133. When the substrate 133 is inserted into the accommodation cavity 122, the surface 136 of the substrate 133 is exposed outside the mounting base 12 as a contact surface with the chip. The position-limiting protrusion 123 is in contact with the position-limiting protrusion 131 to limit a position at which the heat-conducting plate 13 is inserted into the mounting base 12. When the mounting base 12 is in another structure form, the substrate 133 of the heat-conducting plate 13 may be relatively disposed in a corresponding structure, so that the substrate 133 adapts to the accommodation cavity of the mounting base 12.

Referring to FIG. 10, the heat dissipation structure 135 of the heat-conducting plate 13 may use a capillary structure 1351. The capillary structure 1351 has a plurality of connected holes inside, and the plurality of holes are used to form a liquid channel for liquid flowing. When the heat-conducting plate 13 fits with the mounting base 12, the capillary structure 1351 of the heat-conducting plate 13 is located on the surface 137 of the heat-conducting plate 13, and is located above the mounting base 12. The "above" refers to a reference direction of a placement direction of the heat-conducting plate 13 in FIG. 5. Still referring to FIG. 10, the capillary structure 1351 in FIG. 10 uses a porous structure, for example, a porous structure formed by sintering a metal powder or a metal mesh. When the metal mesh is used to form the capillary structure 1351, the metal mesh is woven by using a metal wire, uses a porous structure, and is welded to the substrate 133 by using a single-layer or multi-layer mesh, to form a connected liquid channel (not shown in the figure). When the capillary structure 1351 made by sintering the metal powder is used, the metal powder is sintered into a spherical granular structure, a gap is formed between the spherical granular structures, and the gap is connected to form the liquid channel. However, regardless of whether the capillary structure 1351 is made by using the metal powder or the metal mesh, the metal powder or the metal mesh uses metal, an alloy with a good heat-conducting effect, or another material with a high heat-conducting property, for example, different metals such as copper, aluminum, or iron.

When the heat-conducting plate uses the foregoing structure, the pressing plate may seal the liquid channel on the heat-conducting plate, to avoid liquid leakage. Referring to FIG. 10 and FIG. 11, FIG. 11 is a schematic exploded diagram of a heat-conducting plate according to this application. A placement groove 1331 is disposed on the substrate 133, and a sealing gasket 134 is disposed in the placement groove 1331. When the placement groove 1331 is disposed, the placement groove 1331 surrounds the capillary structure 1351, and the sealing gasket 134 is disposed in the placement groove 1331. In addition, when the pressing plate is in contact with the heat-conducting plate 12, the pressing plate is sealed with the heat-conducting plate 12 by using the sealing gasket 134.

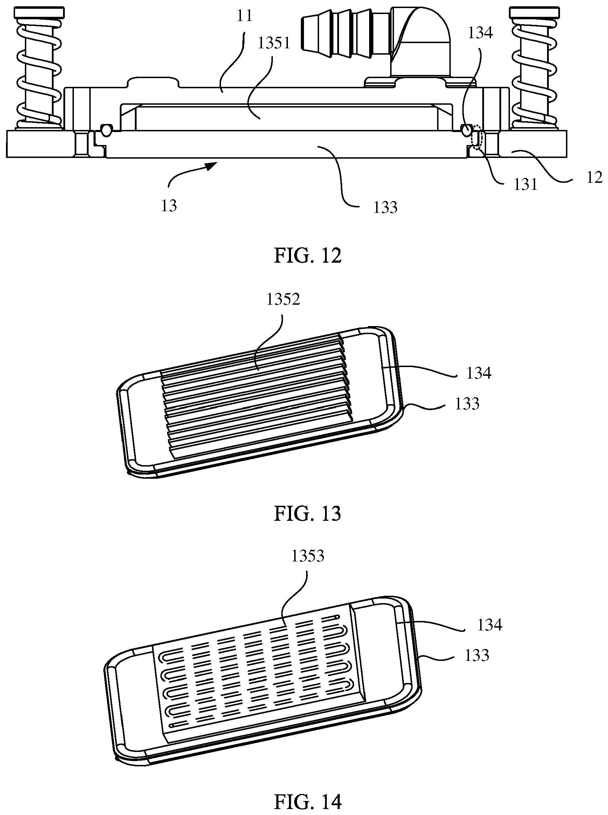

FIG. 12 is a sectional view of a heat dissipation apparatus according to this application. FIG. 12 is a schematic diagram of along a laminated direction of the pressing plate, the heat-conducting plate, and the mounting base in FIG. 2. As shown in the figure, when the pressing plate 11 covers the mounting base 12, the pressing plate 11 and the substrate 133 are sealed and connected by using the sealing gasket 134, and the capillary structure 1351 is sealed in a sealing cavity surrounded by the substrate 133 and the pressing plate 11. Optionally, a placement groove may also be disposed on the pressing plate 11, and the sealing gasket 134 is fastened in the placement groove of the pressing plate 11, so that the pressing plate 11 and the substrate 133 can be sealed and connected.

In a possible embodiment, FIG. 13 is a schematic diagram of a second type of heat-conducting plate 13 according to this application. For a part that has a same reference sign as that in FIG. 4 or FIG. 5, refer to the description of the structure of the heat-conducting plate in FIG. 11. A difference between the heat-conducting plate 13 in FIG. 13 and the heat-conducting plate 13 in FIG. 11 lies in that liquid channels of the heat-conducting plate 13 are different. As shown in FIG. 13, a plurality of metal sheets 1352 are disposed on the substrate 133, and the plurality of metal sheets 1352 are spaced to form a connected liquid channel (not shown in the figure). When the heat-conducting plate 13 fits with the mounting base 12 and the pressing plate, reference may be made to the description of the example in FIG. 12. Certainly, in a specific implementation solution, a protrusion may be disposed on the heat-conducting plate 13, and an S-shaped groove is disposed in the protrusion as the liquid channel.

In another possible embodiment, FIG. 14 shows a third type of heat-conducting plate 13 according to this application. For a part that has a same reference sign as that in FIG. 11, refer to the description of the structure of the heat-conducting plate in FIG. 11. A difference between the heat-conducting plate 13 in FIG. 14 and the heat-conducting plate 13 in FIG. 11 lies in that liquid channel structures of the heat-conducting plate 13 are different. As shown in FIG. 14, an S-shaped pipe 1353 is disposed on the substrate 133 of the heat-conducting plate 13, and the pipe 1353 forms a liquid channel. When the heat-conducting plate 13 fits with the mounting base 12 and the pressing plate, reference may be made to the description of the example in FIG. 12.

It should be noted that structures of different liquid channels of the heat-conducting plate may be combined and used according to a service requirement and various implementations of the mounting base. This is not limited in this application.

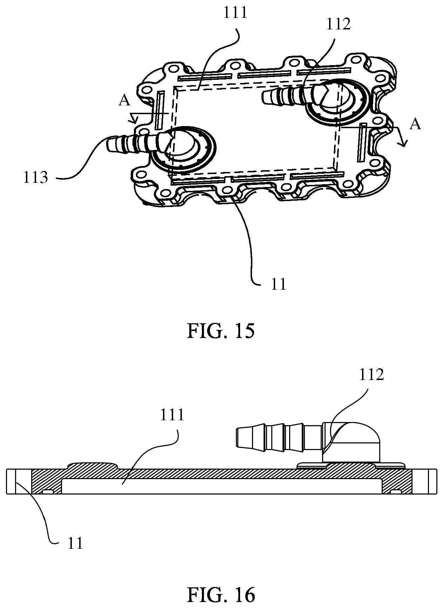

Referring to FIG. 12 and FIG. 15, FIG. 15 is a schematic structural diagram of the pressing plate 11. The pressing plate 11 is configured to be firmly connected to the mounting base 12. Referring to FIG. 15 and FIG. 16, FIG. 16 is a sectional view along A-A in FIG. 15. An accommodation groove 111 that accommodates a plurality of capillary structures is disposed on the pressing plate 11 (shown by a dashed-line box in FIG. 15, where the dashed-line box represents that the accommodation cavity is an internal structure of the pressing plate 11). When the pressing plate 11 is firmly connected to the mounting base, as shown in FIG. 12, the substrate 133 of the heat-conducting plate 13 is located in the accommodation cavity, and the capillary structure 1351 of the heat-conducting plate 13 is located in the accommodation groove of the pressing plate 11. In addition, a groove wall of the accommodation groove and the substrate 133 are sealed by using the sealing gasket 134, so that a sealing cavity is formed between the pressing plate 11 and the heat-conducting plate 13, and the liquid channel (the capillary structure 1351) of the heat-conducting plate 13 is located in the sealing cavity. In addition, liquid is filled in the sealing cavity, so that the pressing plate 11 and the substrate 133 seal the capillary structure 1351, to ensure that the liquid filled in the liquid channel does not leak. The liquid may be common liquid such as water or oil.

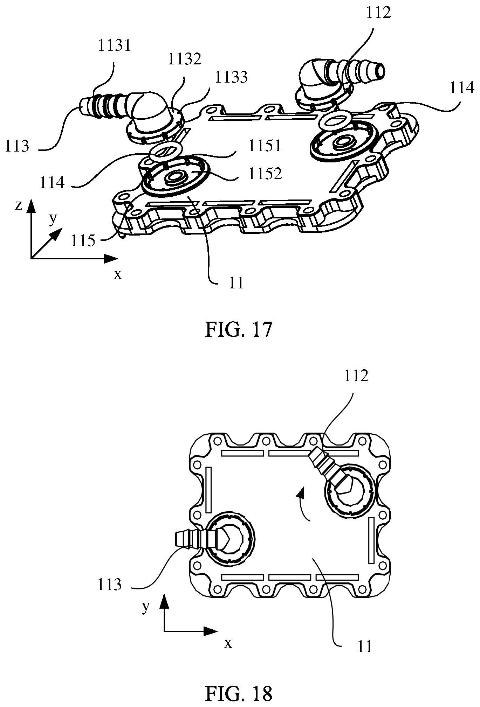

Referring to FIG. 15 and FIG. 17, FIG. 17 is a schematic exploded diagram of the pressing plate in FIG. 15. A liquid inlet connector 113 and a liquid outlet connector 112 that are connected to a liquid channel are disposed on the pressing plate 11, and the liquid inlet connector 113 and the liquid outlet connector 112 are separately configured to connect to an external pipe.

Referring to FIG. 17, for ease of description, a coordinate system xyz is established, where an x-axis direction and a y-axis direction are respectively parallel to two sides of the pressing plate, and a z-axis direction is perpendicular to the x-axis direction and the y-axis direction. As shown in FIG. 17, a connection manner between the liquid inlet connector 113 and the pressing plate 11 is the same as a connection manner between the liquid outlet connector 112 and the pressing plate 11. For brevity, the liquid inlet connector 113 is used as an example for description in the following. A boss 115 corresponding to the liquid inlet connector 113 is disposed on the pressing plate 11, the boss 115 has a mounting groove 1152, the boss 115 has a through hole (not marked in the figure) that connects to the accommodating groove of the pressing plate 11, and the through hole is connected to the mounting groove 1152. The liquid inlet connector 113 is an inverted L-shaped connector, and the liquid inlet connector 113 includes a horizontal part and a vertical part connected to the horizontal part. As shown in FIG. 17, the horizontal part is parallel to the x-axis direction, and the vertical part is parallel to the z-axis direction. The horizontal part of the liquid inlet connector 113 includes a plurality of protrusion structures 1131 arranged in a length direction of the horizontal part. The protrusion structures 1131 are configured to clamp a liquid inlet pipe. When the liquid inlet pipe is connected to the liquid inlet connector 113, the liquid inlet pipe is tightly locked on the liquid inlet connector 113 by using the protrusion structures 1131. The vertical part of the liquid inlet connector 113 has a convex shoulder 1132. When the convex shoulder 1132 is assembled in the mounting groove 1152, the convex shoulder 1132 is directly inserted into the mounting groove 1152, and the liquid inlet connector 113 is connected to the accommodating groove of the pressing plate 11 through the through hole in the mounting groove 1152. A sealing ring 114 is provided between the liquid inlet connector 113 and the pressing plate 11, and the liquid inlet connector 113 and the pressing plate 11 are sealed by using the sealing ring 114. When the liquid inlet connector 113 is connected to the pressing plate 11, a cavity in the liquid inlet connector 113 is connected to the accommodating groove through the through hole, and after the pressing plate 11 and the substrate are sealed to form the liquid channel, the liquid inlet connector 113 is connected to the liquid channel. After the liquid outlet connector 112 is connected to the pressing plate 11, the liquid outlet connector 112 is also connected to the liquid channel.

In FIG. 15, a shape of the pressing plate 11 matches a shape and a size of the mounting base. When the mounting base is a rectangle, a corresponding shape of the pressing plate 11 is also a rectangle. When the mounting base is in another shape, the pressing plate 11 is in a matched shape. Using FIG. 11 as an example, the liquid inlet connector 113 and the liquid outlet connector 112 are disposed in a diagonal manner, so that when the liquid inlet connector 113 and the liquid outlet connector 112 are connected to the liquid channel, the liquid inlet connector 113 and the liquid outlet connector 112 may respectively be connected to two ends of the liquid channel. This enables the liquid to flow a relatively long distance in the liquid channel, enlarges an area of a to-be-heat-dissipated apparatus component whose heat can be conducted by a using liquid medium, and further improves a heat dissipation effect of the liquid on the chip during flowing.

Optionally, in addition to the manner in FIG. 15, the liquid inlet connector 113 and the liquid outlet connector 112 may alternatively be located on a same side of the pressing plate 11. A specific setting manner may be correspondingly set based on a liquid channel setting manner. If two ends of the liquid channel are located on a same side, the liquid inlet connector 113 and the liquid outlet connector 112 are also located on a same side. If two ends of the liquid channel are disposed in a diagonal manner, the liquid inlet connector 113 and the liquid outlet connector 112 are also disposed in a diagonal manner.

Referring to FIG. 17, the mounting groove 1152 may be a cylindrical groove, and the corresponding convex shoulder 1132 is also of a cylindrical structure, so that the convex shoulder 1132 rotates in the mounting groove 1152. Optionally, to limit rotation of the convex shoulder 1132 in the mounting groove 1152, a side wall of the mounting groove 1152 has a plurality of position-limiting protrusions 1151, and the convex shoulder 1132 has a position-limiting groove 1133 fitting with each position-limiting protrusion 1151. When the convex shoulder 1132 is inserted into the mounting groove 1152, the position-limiting protrusions 1151 and the position-limiting grooves 1133 are in a one-to-one correspondence for fitting, to limit rotation of the convex shoulder 1132. A quantity of the position-limiting protrusions 1151 may be set as required, for example, different quantities such as four, eight, or ten. Optionally, in addition to the limiting manner in FIG. 17, a side wall of the mounting groove may alternatively have a plurality of position-limiting grooves, and the convex shoulder has a position-limiting protrusion fitting with each position-limiting groove. Alternatively, the mounting groove may be in a shape of a polygonal prism, and a corresponding convex shoulder may also be in a shape of a matched polygonal prism. By using the structure, after angles of the liquid inlet connector 113 and the liquid outlet connector 112 are selected, the liquid inlet connector 113 and the liquid outlet connector 112 may be fastened by using the convex shoulder 1132 and the mounting groove 1152, to avoid that a change in the angles of the liquid inlet connector 113 and the liquid outlet connector 112 caused by device oscillation or other collisions affects circulation of liquid in the liquid channel.

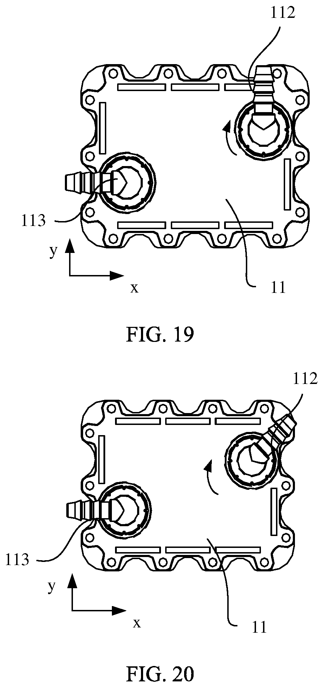

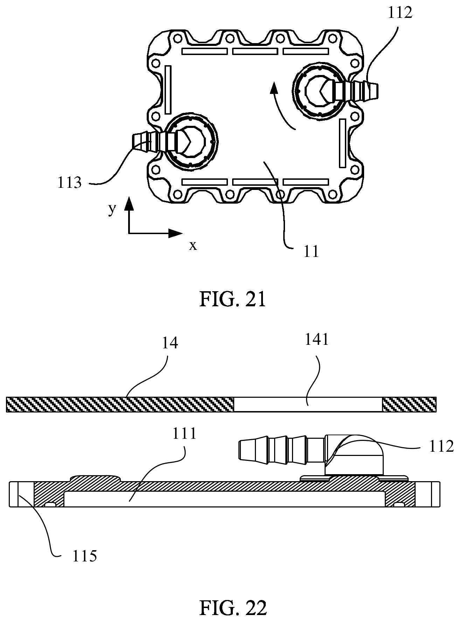

When the structure in FIG. 17 is used, both the liquid inlet connector 113 and the liquid outlet connector 112 can implement rotation based on the pressing plate. In other words, both directions of the liquid inlet connector 113 and the liquid outlet connector 112 can be changed, and it is ensured, by using the position-limiting protrusion 1151 and the position-limiting groove 1133, that the liquid inlet connector 113 and the liquid outlet connector 112 after rotating can be firmly connected to the pressing plate. Referring to FIG. 18 to FIG. 21, FIG. 18 to FIG. 21 are schematic diagrams of rotating the liquid inlet connector 113 and the liquid outlet connector 112 to different states. First, referring to FIG. 18, for ease of description, an x-y coordinate system is established, where an x-axis direction is parallel to a long side edge of the pressing plate 11, and a y-axis direction is parallel to a short side edge of the pressing plate 11. The liquid inlet connector 113 is in a direction of the x-axis (a placement direction of the pressing plate 11 in FIG. 18 is used as a reference direction), and the liquid outlet connector 112 is in a direction obliquely upward, and has an angle of 60° with the direction of the x-axis. When the direction of the liquid outlet connector 112 needs to be adjusted, the convex shoulder of the liquid outlet connector 112 is first removed from the mounting groove, then the liquid inlet connector 113 is rotated out in a direction indicated by an arrow in FIG. 18, the convex shoulder of the liquid inlet connector 113 is inserted into the mounting groove again, and the position-limiting groove on the convex shoulder fits with the position-limiting protrusion in the mounting groove to limit the liquid inlet connector 113 not to rotate. A direction of the liquid inlet connector 113 is shown in FIG. 19, and the liquid outlet connector 112 rotates to the direction of the y axis. When the liquid outlet connector 112 needs to be adjusted again in the direction indicated by the arrow in FIG. 19, the foregoing operations are repeated, and the liquid outlet connector 112 rotates to a state in FIG. 20. In this case, the liquid outlet connector 112 rotates to having an angle of 120° with the direction of the x axis. When the liquid outlet connector 112 needs to be adjusted again in the direction indicated by the arrow in FIG. 20, the foregoing operations are repeated, and the liquid outlet connector 112 rotates to a state in FIG. 21. In this case, the liquid outlet connector 112 rotates to the direction of the x-axis, and the direction of the liquid outlet connector 112 is opposite to the direction of the liquid inlet connector 113. It can be learned from the processes in FIG. 18 to FIG. 21 that the liquid outlet connector 112 may rotate to different angles as required. When the liquid outlet connector 112 is connected to a liquid outlet pipe of a cooling system, a position of the liquid outlet connector 112 may be adjusted based on a setting position of the liquid outlet pipe, to facilitate the liquid outlet connector 112 to be connected to the cooling system. For a rotation manner of the liquid inlet connector 113, refer to rotation of the liquid outlet connector 112. Details are not described herein again.

In a possible embodiment, based on the structures in FIG. 18 to FIG. 21, the heat dissipation apparatus may further be fastened by using a pressing cover. FIG. 22 is a schematic structural diagram of a pressing plate and a pressing cover according to this application. In FIG. 22, for a part that has a same reference sign as that in FIG. 17, refer to the description of the structure of the pressing plate 11 in FIG. 17. As shown in the figure, when the liquid inlet connector 113 and the liquid outlet connector 112 are connected to the pressing plate 11 in the foregoing manner, the liquid inlet connector 113 and the liquid outlet connector 112 are fastened to the pressing plate 11 by using the pressing cover 14. The pressing cover 14 is stacked on a side that is of the pressing plate 11 and that is away from the accommodating groove 111, and a through hole 141 fitting with the liquid inlet connector 113 and the liquid outlet connector 112 is disposed on the pressing cover 14. The pressing cover 14 is configured to be firmly connected to the mounting base, where the fastened connection may be detachable, and the pressing plate 14 is tightly pressed onto the heat-conducting plate. For example, the pressing cover 14 is connected to the mounting base by using a threaded connecting piece (a bolt or a screw), and the pressing plate 11 is tightly pressed onto the mounting base. In addition, the pressing cover 14 also tightly presses the liquid outlet connector and the liquid inlet connector onto the pressing plate 11. During connection, the threaded connecting piece sequentially passes through the pressing cover 14, the pressing plate 11, and the mounting base, and fastens the pressing cover 14 and the pressing plate 11 onto the mounting base. When angles of the liquid inlet connector and the liquid outlet connector are adjusted, the pressing cover 14 may be first removed, and then the liquid inlet connector or the liquid outlet connector each are rotated to an angle as required. Then, the pressing cover 14 is firmly connected to the mounting base, and tightly presses the liquid inlet connector and the liquid outlet connector onto the pressing plate 11. Optionally, the pressing cover 14 may be made of a material with relatively high stiffness, for example, stainless steel, iron, or aluminum alloy, and the pressing plate 11 may be made of plastic or another material with relatively low stiffness. The pressing cover 14 enhances pressure strength of the entire pressing plate 11 on the heat-conducting plate and the mounting base. In a process of liquid flowing in the heat-conducting plate, the pressing plate 11 and the pressing cover 14 may be used to jointly fasten the heat-conducting plate. In addition, when the device falls down or the device is placed upside down, the pressing cover 14 may assist the pressing plate 11 in fastening the heat-conducting plate and the mounting base. This can avoids that flowing out of the liquid in the heat dissipation apparatus affects a heat dissipation effect of the heat dissipation apparatus.

FIG. 17 and FIG. 22 are merely examples of the pressing plate according to this application. In specific implementation, the liquid inlet connector 113 may alternatively be rotatably connected to the pressing plate, and the liquid outlet connector 112 may be rotatably connected to the pressing plate. For example, the liquid inlet connector 113 and/or the liquid outlet connector 112 are/is rotatably connected to the pressing plate 11. Specifically, any one of the following manners is included:
Manner 1: The liquid inlet connector 113 and the pressing plate 11 may be firmly connected, and the liquid outlet connector 112 and the pressing plate 11 are rotatably connected.
Manner 2: The liquid inlet connector 113 is rotatably connected to the pressing plate 11, and the liquid outlet connector 112 is firmly connected to the pressing plate 11.
Manner 3: The liquid inlet connector 113 is rotatably connected to the pressing plate 11, and the liquid outlet connector 112 is also rotatably connected to the pressing plate 11.

Optionally, the liquid inlet connector 113 and the liquid outlet connector 112 may alternatively be directly and rotatably connected to the pressing plate 11 in a clamping manner. In this case, a reliable connection between the liquid inlet connector 113, the liquid outlet connector 112, and the pressing plate 11 can also be ensured without using the pressing cover. However, when this structure is used, the pressing plate 11 has specific strength. When the pressing plate 11 is firmly connected to the mounting base, the pressing plate 11 need to have sufficient stiffness to ensure a sealing effect between the pressing plate 11 and the substrate.

When the pressing plate 11 is connected to the mounting base, the pressing plate 11 is connected to the mounting base by using a threaded connecting piece (for example, a bolt or a screw), for example, a bolt or a screw. In addition, the threaded connecting piece is sleeved with a waterproof sealing ring. When the pressing plate 11 and the mounting base are connected by using the threaded connecting piece, the waterproof sealing ring seals a gap between the threaded connecting piece and the pressing plate. This improves a sealing effect.

In addition, the liquid inlet connector 113 and the liquid outlet connector 112 each may further be firmly connected to the pressing plate 11. In this case, neither the liquid inlet connector 113 nor the liquid outlet connector 112 can rotate relative to the pressing plate 11. During specific manufacturing, the liquid inlet connector 113, the liquid outlet connector 112, and the pressing plate 11 may be made and formed by using an integrally formed manufacturing process. This ensures sealing between the liquid inlet connector 113, the liquid outlet connector 112, and the pressing plate 11.

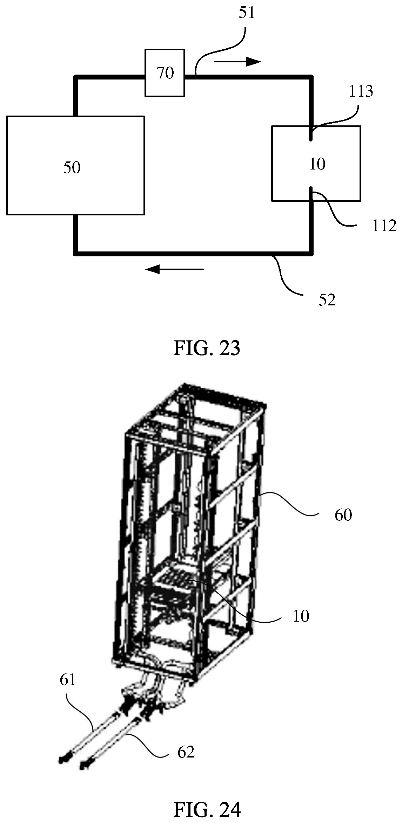

The liquid heat dissipation apparatus may be applied to a device, and a connection manner between the heat dissipation apparatus and a cooling system that are in the device is shown in FIG. 23. The cooling system includes a power apparatus 70 configured to enable liquid to flow in a liquid channel, and a cooling apparatus 50 configured to cool liquid. As shown in FIG. 23, a liquid inlet of the cooling apparatus 50 is connected to a liquid inlet pipe 51, the liquid inlet pipe 51 is sealed with and connected to the liquid inlet connector 113, a liquid outlet pipe 52 is sealed with and connected to the liquid outlet connector 112, and the liquid outlet pipe 52 is connected to the liquid inlet of the cooling apparatus 50. This forms a liquid circulation loop. In a heat dissipation process, the liquid flows in the circulation loop, as shown by an arrow in FIG. 23, and the liquid flows clockwise. In addition, in a flowing process, cold liquid in the cooling apparatus 50 enters the liquid inlet pipe 51 by being driven by the power apparatus 70, and enters a sealing cavity of the heat dissipation apparatus 10 by flowing through the liquid inlet connector 113. Heat generated by a chip is transferred to the liquid by using the heat-conducting plate, a temperature of the liquid increases after absorbing the heat, and the high-temperature liquid flows back to the cooling apparatus 50 through the liquid outlet connector 112 and the liquid outlet pipe 52 for cooling. The cooled liquid flows into the heat dissipation apparatus 10 again through the liquid inlet pipe 51 and the liquid inlet connector 113, to cyclically dissipate heat for the chip. The power apparatus 70 may be a plunger pump or another pump, and the cooling apparatus may be a condenser or another apparatus that can provide cooling. In addition, in FIG. 23, the power apparatus 70 is disposed on the liquid inlet pipe 51. However, it should be understood that the power apparatus 70 in FIG. 23 is merely an example, and the power apparatus 70 may also be disposed on the liquid outlet pipe 52.

FIG. 23 shows only an example of a manner in which the cooling system is connected to one heat dissipation apparatus 10. When there are a plurality of heat dissipation apparatuses, the plurality of heat dissipation apparatuses may be disposed in parallel or in series. When the heat dissipation apparatuses 10 are disposed in parallel, liquid flowing out of the cooling apparatus 50 flows into the plurality of heat dissipation apparatuses 10 at the same time. When the heat dissipation apparatuses 10 are disposed in series, liquid flowing out of the cooling apparatus 50 sequentially flows through the plurality of heat dissipation apparatuses 10.

It can be learned from the foregoing description that the heat dissipation apparatus provided in this embodiment of this application is disposed in a sandwich laminated manner. In addition, the mounting base and the pressing plate may be made into standard parts. For chips having different heat dissipation requirements, only a heat-conducting plate needs to be replaced. For example, a same type of device has a first chip or a second chip, where the first chip and the second chip have different heat dissipation requirements. During assembly, a mounting base may be fastened onto the first chip or the second chip, and a cavity in the middle of the mounting base faces the first chip or the second chip. A heat-conducting plate corresponding to the first chip or the second chip is selected according to a heat dissipation requirement, and then a unified pressing plate is assembled on a corresponding mounting base. During the foregoing assembly, optionally, a first surface of the heat-conducting plate is at least not less than a surface area of a second surface of the chip, where the first surface is a surface that is of the heat-conducting plate and that is used to be in contact with the chip in a heat-conducting manner, and the second surface is a surface that is of the chip and that is used to connect to the heat-conducting plate in a heat-conducting manner. In other words, during use, an area of the accommodation cavity should be at least not less than the second surface of the chip. Therefore, an area of the disposed mounting base should be greater than an area of a corresponding chip. It can be learned from the foregoing description that, for chips having different heat dissipation requirements, the only difference between heat dissipation apparatuses corresponding to the chips is that the heat-conducting plates between the mounting base and the pressing plate are different. Therefore, the heat dissipation apparatus provided in this embodiment of this application may be applied to the chips having different heat dissipation requirements, provided that a corresponding heat-conducting plate is used according to a heat dissipation requirement, and an entire heat dissipation apparatus does not need to be replaced. Compared with an integral liquid heat dissipation apparatus, the heat dissipation apparatus in the present invention eliminates the need to select different liquid heat dissipation apparatuses for different chips, and improves adaptability of the heat dissipation apparatus. In addition, during maintenance of the heat dissipation apparatus provided in this application, only the heat-conducting plate needs to be replaced, and the mounting base and the pressing plate may continue to be used. This reduces maintenance costs.

In addition, according to a modularized standard, only different molds need to be selected for the heat-conducting plate according to a corresponding requirement of the chip, and the mounting base and the pressing plate may be made by using a unified mold. This reduces production difficulty of the heat dissipation apparatus and reduces manufacturing costs of the heat dissipation apparatus.

In addition, the liquid inlet connector and the liquid outlet connector that are connected to the pressing plate may also be made into standard parts, to facilitate pipe connection of the cooling system.

This application provides a device. As shown in FIG. 1, the device may be a server, a memory, a router, a switch, or the like. As shown in FIG. 1, a chip 20 is born by a mainboard 30 of the device, and a heat dissipation apparatus is detachably and firmly connected to the mainboard 30 that bears the chip 20. When a heat dissipation apparatus 10 is used, reference may be made to FIG. 23. When the heat dissipation apparatus 10 is used, the device has a cooling apparatus 50, a liquid inlet pipe 51 in the cooling apparatus 50 is connected to a liquid inlet connector 113, and a liquid outlet pipe 52 is connected to a liquid outlet connector 112, to form a circulation loop. During use, liquid flows in the circulation loop, as shown by an arrow in FIG. 23, and the liquid flows clockwise. In addition, in a flowing process, cold liquid in the cooling apparatus 50 enters a sealing cavity of the heat dissipation apparatus 10 through the liquid inlet pipe 51 and the liquid inlet connector 113. Heat generated by a chip is transferred to the liquid by using a heat-conducting plate, a temperature of the liquid increases after absorbing the heat, and the high-temperature liquid flows back to the cooling apparatus 50 through the liquid outlet connector 112 and the liquid outlet pipe 52 for cooling. The cooled liquid flows into the heat dissipation apparatus 10 again through the liquid inlet pipe 51 and the liquid inlet connector 113, to cyclically dissipate heat for the chip.

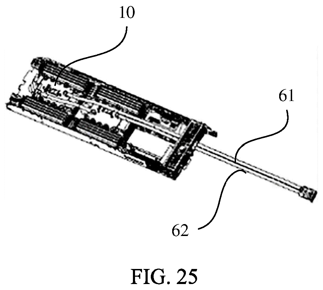

In a possible embodiment, this application further provides a rack. As shown in FIG. 24 and FIG. 25, FIG. 24 is a schematic diagram of the rack.

FIG. 25 is a schematic diagram of connection between a heat dissipation apparatus and a cooling system. During use, a device is assembled on the rack 60, and the rack may include a plurality of devices, or may include only one device. The device may be a server, a storage device, a router, or a switch. The storage device includes a data storage device such as a storage array or a backup device. A cooling system (not shown in the figure) is disposed on the rack, and the cooling system is connected to a liquid inlet pipe 61 and a liquid outlet pipe 62. The liquid inlet pipe 61 is connected to a liquid inlet connector of a heat dissipation apparatus 10, and the liquid outlet pipe 62 is connected to a liquid outlet connector of the heat dissipation apparatus. Optionally, the cooling system further includes a power apparatus (for example, a pump) for implementing liquid flowing in a liquid channel and a cooling apparatus configured to cool the liquid, so that the cooling system and the heat dissipation apparatus form a circulation loop, and the liquid flows clockwise or counterclockwise. In addition, in a flowing process, cold liquid in the cooling apparatus enters a sealing cavity of the heat dissipation apparatus 10 through the liquid inlet pipe 61 and the liquid inlet connector. Heat generated by a chip is transferred to the liquid by using the heat-conducting plate, a temperature of the liquid increases after absorbing the heat, and the high-temperature liquid flows back to the cooling apparatus through the liquid outlet connector and the liquid outlet pipe 62 for cooling. The cooled liquid flows into the heat dissipation apparatus 10 again through the liquid inlet pipe 61 and the liquid inlet connector 113, to cyclically dissipate heat for the chip.

This application further provides a heat dissipation system. A structure of the heat dissipation system is similar to the structure in FIG. 23 or FIG. 24, and includes a heat dissipation apparatus and a cooling system. The heat dissipation apparatus is of the structure in FIG. 1. The cooling system includes a power apparatus configured to enable liquid to flow in a liquid channel and a cooling apparatus configured to cool liquid, so that the cooling system and the heat dissipation apparatus form a circulation loop. The liquid flows clockwise or counterclockwise, heat of a to-be-heat-dissipated chip is conducted to the cooling apparatus by flowing of the liquid in the liquid channel, and the cooling apparatus cools the liquid. This implements heat dissipation for the to-be-heat-dissipated chip.

"First" in the first surface and the first position-limiting protrusion mentioned in this application is merely used as a name identifier, and does not represent the first in sequence. The rule is also applicable to "second", "third", and the like.

The term "and/or" in this application is used to describe an association relationship between associated objects and indicates that three relationships may exist. For example, A and/or B may represent the following cases: Only A exists, both A and B exist, and only B exists. In addition, the character "/" in this specification generally indicates an "or" relationship between the associated objects.

In this application, unless otherwise explicitly specified and limited, a term "connection" should be understood in a broad sense. For example, the "connection" may be a fastened connection, a detachable connection, or an integrated connection; and may be a direct connection or an indirect connection by using an intermediate medium.

Further embodiments of the present invention are provided in the following. It should be noted that the numbering used in the following section does not necessarily need to comply with the numbering used in the previous sections.

Embodiment 1. A heat dissipation apparatus, comprising:
a heat-conducting plate, wherein the heat-conducting plate comprises a first surface and a second surface that are opposite to each other, and a liquid channel is disposed on the first surface;
a mounting base, wherein an accommodation cavity configured to accommodate a partial area that is in the heat-conducting plate and that comprises the second surface is disposed on the mounting base; and
a pressing plate, configured to fasten the heat-conducting plate in the accommodation cavity, the pressing plate is detachably and firmly connected to the mounting base, a sealing cavity is formed between the pressing plate and the first surface of the heat-conducting plate, the sealing cavity is configured to accommodate the liquid channel, and a liquid inlet connector and a liquid outlet connector that are connected to the liquid channel are disposed on the pressing plate.

Embodiment 2. The heat dissipation apparatus according to claim 1, wherein the heat-conducting plate comprises a substrate configured to be clamped into the accommodation cavity, and a heat dissipation structure firmly disposed on the substrate, and the heat dissipation structure is the liquid channel.

Embodiment 3. The heat dissipation apparatus according to claim 2, wherein a first position-limiting protrusion is disposed in the accommodation cavity of the mounting base, and a second position-limiting protrusion clamped with the first position-limiting protrusion is disposed on the substrate.

Embodiment 4. The heat dissipation apparatus according to claim 2, wherein a position-limiting protrusion is disposed on the substrate, and the position-limiting protrusion abuts against a surface of the mounting base.

Embodiment 5. The heat dissipation apparatus according to any one of claims 1 to 4, wherein the pressing plate is sealed with and connected to the substrate by using a sealing gasket.

Embodiment 6. The heat dissipation apparatus according to any one of claims 1 to 5, further comprising a pressing cover, wherein the pressing cover is detachably and firmly connected to the mounting base, and the pressing cover is pressed onto the heat-conducting plate.

Embodiment 7. The heat dissipation apparatus according to any one of claims 1 to 6, wherein at least one of the liquid inlet connector and the liquid outlet connector is rotationally connected to the pressing plate.

Embodiment 8. The heat dissipation apparatus according to any one of claims 1 to 7, wherein an accommodation groove that accommodates the heat dissipation structure is disposed on the pressing plate.

Embodiment 9. The heat dissipation apparatus according to any one of claims 1 to 8, wherein the pressing cover tightly presses the liquid outlet connector and the liquid inlet connector onto the pressing plate.

Embodiment 10. The heat dissipation apparatus according to claim 9, wherein bosses that are in a one-to-one correspondence with the liquid inlet connector and the liquid outlet connector are disposed on the pressing plate, each boss has a mounting groove, the liquid inlet connector or the liquid outlet connector has a convex shoulder assembled in the mounting groove, and the pressing cover tightly presses the convex shoulder into the mounting groove.

Embodiment 11. The heat dissipation apparatus according to claim 10, wherein when the pressing cover does not tightly press the convex shoulder into the mounting groove, the convex shoulder may rotate relative to the mounting groove.

Embodiment 12. The heat dissipation apparatus according to claim 11, wherein a side wall of the mounting groove has a plurality of position-limiting protrusions, and the convex shoulder has a position-limiting groove fitting with each position-limiting protrusion; or
a side wall of the mounting groove has a plurality of position-limiting grooves, and the convex shoulder has a position-limiting protrusion fitting with each position-limiting groove.

Embodiment 13. The heat dissipation apparatus according to any one of claims 1 to 12, wherein the pressing plate is a rectangle, and the liquid inlet connector and the liquid outlet connector are disposed in a diagonal manner.

Embodiment 14. The heat dissipation apparatus according to any one of claims 1 to 13, wherein a floating screw configured to connect to a chip is disposed on the mounting base.

Embodiment 15. The heat dissipation apparatus according to any one of claims 1 to 14, wherein an area of the second surface of the heat-conducting plate is greater than or equal to a surface area of a to-be-heat-dissipated chip, and the second surface is a surface that is of the heat-conducting plate and that is used to conduct heat for the chip.

Embodiment 16. The heat dissipation apparatus according to any one of claims 1 to 15, wherein the sealing cavity is filled with liquid, and the liquid flows in the liquid channel.

Embodiment 17. The heat dissipation apparatus according to any one of claims 1 to 16, wherein the heat dissipation apparatus is connected to a cooling system, and

cold liquid in the cooling system enters the sealing cavity of the heat dissipation apparatus, heat generated by the chip is transferred to the liquid by using the heat-conducting plate, and the liquid absorbs the heat and then flows back to the cooling system for cooling.

Embodiment 18. The heat dissipation apparatus according to any one of claims 1 to 17, wherein stiffness of the pressing cover is greater than stiffness of the pressing plate.

Embodiment 19. A device, wherein the device comprises:
a mainboard;
a chip mounted on the mainboard; and
the heat dissipation apparatus according to any one of claims 1 to 18, wherein the heat dissipation apparatus is firmly connected to the mainboard and configured to dissipate heat for the chip.

Embodiment 20. The device according to claim 19, wherein the device is connected to a cooling system, the cooling system comprises a liquid inlet pipe and a liquid outlet pipe, the liquid inlet pipe is sealed with and connected to a liquid inlet connector of the heat dissipation apparatus, and the liquid outlet pipe is sealed with and connected to a liquid outlet connector of the heat dissipation apparatus; and the cooling system further comprises a power apparatus configured to enable liquid to flow in a liquid channel, and a cooling apparatus configured to cool the liquid.

Embodiment 21. A rack, comprising: the heat dissipation apparatus according to any one of claims 1 to 18 installed on the rack, or the device according to claim 19 or 20.

Embodiment 22. A system, comprising the heat dissipation apparatus and the cooling system according to any one of claims 1 to 18, wherein the cooling system comprises a power apparatus configured to enable liquid to flow in a liquid channel in the heat dissipation apparatus and a cooling apparatus configured to cool liquid in the heat dissipation apparatus.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus, comprising:
a heat-conducting plate, wherein the heat-conducting plate comprises a first surface and a second surface that are opposite to each other, and a liquid channel is disposed on the first surface;
a mounting base, wherein an accommodation cavity configured to accommodate a partial area that is in the heat-conducting plate and that comprises the second surface is disposed on the mounting base; and
a pressing plate, configured to fasten the heat-conducting plate in the accommodation cavity, wherein the pressing plate is detachably and firmly connected to the mounting base, a sealing cavity is formed between the pressing plate and the first surface of the heat-conducting plate, the sealing cavity is configured to accommodate the liquid channel, and a liquid inlet connector and a liquid outlet connector that are connected to the liquid channel are disposed on the pressing plate.

2. The heat dissipation apparatus according to claim 1, wherein the heat-conducting plate comprises a substrate configured to be clamped into the accommodation cavity, and a heat dissipation structure firmly disposed on the substrate, and the heat dissipation structure is the liquid channel.

3. The heat dissipation apparatus according to claim 2, wherein a first position-limiting protrusion is disposed in the accommodation cavity of the mounting base, and a second position-limiting protrusion clamped with the first position-limiting protrusion is disposed on the substrate.

4. The heat dissipation apparatus according to claim 2, wherein a position-limiting protrusion is disposed on the substrate, and the position-limiting protrusion abuts against a surface of the mounting base.

5. The heat dissipation apparatus according to any one of claims 1 to 4, wherein the pressing plate is sealed with and connected to the substrate by using a sealing gasket.

6. The heat dissipation apparatus according to any one of claims 1 to 5, further comprising a pressing cover, wherein the pressing cover is detachably and firmly connected to the mounting base, and the pressing cover is pressed onto the heat-conducting plate.

7. The heat dissipation apparatus according to any one of claims 1 to 6, wherein at least one of the liquid inlet connector and the liquid outlet connector is rotationally connected to the pressing plate.

8. The heat dissipation apparatus according to any one of claims 1 to 7, wherein an accommodation groove that accommodates the heat dissipation structure is disposed on the pressing plate.

9. The heat dissipation apparatus according to any one of claims 1 to 8, wherein the pressing cover tightly presses the liquid outlet connector and the liquid inlet connector onto the pressing plate.

10. The heat dissipation apparatus according to claim 9, wherein bosses that are in a one-to-one correspondence with the liquid inlet connector and the liquid outlet connector are disposed on the pressing plate, each boss has a mounting groove, the liquid inlet connector or the liquid outlet connector has a convex shoulder assembled in the mounting groove, and the pressing cover tightly presses the convex shoulder into the mounting groove.

11. The heat dissipation apparatus according to claim 10, wherein when the pressing cover does not tightly press the convex shoulder into the mounting groove, the convex shoulder may rotate relative to the mounting groove.

12. The heat dissipation apparatus according to claim 11, wherein a side wall of the mounting groove has a plurality of position-limiting protrusions, and the convex shoulder has a position-limiting groove fitting with each position-limiting protrusion; or
a side wall of the mounting groove has a plurality of position-limiting grooves, and the convex shoulder has a position-limiting protrusion fitting with each position-limiting groove.

13. The heat dissipation apparatus according to any one of claims 1 to 12, wherein the pressing plate is a rectangle, and the liquid inlet connector and the liquid outlet connector are disposed in a diagonal manner.

14. The heat dissipation apparatus according to any one of claims 1 to 13, wherein a floating screw configured to connect to a chip is disposed on the mounting base.

15. A device, wherein the device comprises:
a mainboard;
a chip mounted on the mainboard; and
the heat dissipation apparatus according to any one of claims 1 to 14, wherein the heat dissipation apparatus is connected to the mainboard and configured to dissipate heat for the chip.
